(19) Europäisches Patentamt
European Patent Office
Office européen des brevets

(11) EP 2 312 614 A2

(12) EUROPEAN PATENT APPLICATION

(43) Date of publication:
**20.04.2011 Bulletin 2011/16**

(51) Int Cl.:
***H01J 37/32*** *(2006.01)*

(21) Application number: **10186987.3**

(22) Date of filing: **08.10.2010**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **14.10.2009 US 251454 P**

(71) Applicants:
- **Greene, Tweed Of Delaware, Inc.**
  **Wilmington, DE 19801 (US)**
- **Daikin Industries, Ltd.**
  **Osaka 530-8323 (JP)**

(72) Inventors:
- **Noguchi, Tsuyoshi**
  **Osaka 566-8585 (JP)**
- **Toshimitsu, Takafumi**
  **Osaka 532-003 (JP)**
- **Alexander, William Brock**
  **Kulpsville, PA 19443-0305 (US)**
- **Hirano, Seiichi**
  **Osaka 566-8585 (JP)**

(74) Representative: **HOFFMANN EITLE**
**Patent- und Rechtsanwälte**
**Arabellastraße 4**
**81925 München (DE)**

# (54) Plasma resistant processing apparatus

(57) There is provided a processing apparatus undergoing various treatments using plasma and protected from plasma so as not to be damaged. The processing apparatus is one using plasma and having a protective layer comprising a fluorine-containing elastomer on the whole or a part of a surface exposed to plasma in the processing apparatus.

EP 2 312 614 A2

Printed by Jouve, 75001 PARIS (FR)

## Description

The present invention relates to a processing apparatus being excellent in plasma resistance which is an apparatus used for producing semiconductors, liquid crystal panels, solar cells, etc. for various treatments such as etching, CVD and ashing by using plasma.

For production of semiconductors, liquid crystal panels and solar cells, apparatuses undergoing various treatments such as etching, chemical vapor deposition (CVD) and ashing by using plasma are used.

These apparatuses using plasma have members exposed to plasma, and materials (substances) giving no adverse effect on each treatment are used on such members. However, there is a problem that deterioration of the members occur while being exposed to highly reactive plasma.

For example, in a plasma etching apparatus shown in the diagrammatic cross-sectional view of Fig. 1, especially significant deterioration occurs on edge portions (Symbol A) forming concave or convex parts of sharp angle and on small spaces (Symbol B) formed by O-ring in a chamber of the apparatus. Therefore, replacement of them must be done frequently, and decrease in productivity cannot be avoided due to shutting down of the apparatus and a production line resulting from the replacement.

In order to inhibit deterioration due to plasma, for example, to make sealing materials such as O-ring using plasma resistant fluorine-containing elastomer material is known (U.S. Patent No. 7495046, U.S. Patent Publication No. 2006/0235140 and U.S. Patent Publication No. 2007/0098978).

It is an object of the present invention to inhibit deterioration of inner surfaces exposed to plasma in a processing apparatus using plasma.

The processing apparatus of the present invention can improve productivity since deterioration due to plasma can be effectively inhibited and operation time of the processing apparatus can be extended.

The present invention relates to a processing apparatus using plasma, which has a protective layer comprising a fluorine-containing elastomer (A) on the whole or a part of surfaces exposed to plasma in the processing apparatus.

The fluorine-containing elastomer (A) constituting the protective layer may be either a not-crosslinked fluorine-containing elastomer or a crosslinked fluorine-containing elastomer.

Also, the fluorine-containing elastomer (A) constituting the protective layer may further comprises a filler.

From the viewpoint of especially excellent plasma resistance, perfluoroelastomer is preferred as the fluorine-containing elastomer (A).

It is preferable that the protective layer is provided at least on a surface of an edge portion exposed to plasma in the processing apparatus and/or on a surface profiling a small space exposed to plasma in the processing apparatus.

Preferred examples of the processing apparatuses using plasma are plasma etching equipment, plasma CVD equipment and ashing equipment.

Fig. 1 is a diagrammatic cross-sectional view of plasma etching equipment.
Fig. 2 is a diagrammatic cross-sectional view of plasma CVD equipment.
Fig. 3 is a diagrammatic cross-sectional view of ashing equipment.

The processing apparatus of the present invention using plasma is characterized by having a protective layer comprising the fluorine-containing elastomer (A) on the whole or a part of surfaces exposed to plasma in the processing apparatus.

Surfaces to be protected may be either overall surfaces or especially a part of surfaces, and it is preferable to protect especially portions being easily subject to deterioration and damage due to plasma.

Examples of portions being easily subject to deterioration and damage due to plasma are edge portions (Symbol A in Figs. 1 to 3) forming concave or convex parts of sharp angle and small spaces (Symbol B in Figs. 1 to 3) formed by O-ring.

In the present invention, portions of the apparatus where the protective layer is formed are explained below using Fig. 1, Fig. 2 and Fig. 3 representing plasma etching equipment, plasma CVD equipment and ashing equipment, respectively.

(1) Plasma etching equipment

A diagrammatic cross-sectional view of plasma etching equipment is shown in Fig. 1. In Fig. 1, numeral 1 is a nozzle for feeding gas, numeral 2 is a lid, numeral 3 is a side wall, numeral 4 is a bottom plate, numeral 5 is a ring, numeral 6 is an electrode, numeral 7 is a side plate of an electrode, numeral 8 is a wafer, numeral 9 is a wafer chuck, numeral 10 is a an exhaust pipe, numeral 11 is a high frequency coil, and numeral 12 are O-rings.

In Fig. 1, the left-hand half thereof shows especially portions to be effectively provided with the protective layer (Symbols A and B), and the right-hand half thereof shows the case that the protective layers 13 and 14 are provided

therewith.

In this plasma etching equipment, examples of edge portions of sharp angle are those indicated by Symbol A, and examples of small spaces are those indicated by Symbol B and formed by O-ring and peripheral members thereof.

The protective layer to be provided on the edge portion A is preferably the protective layer 13 in the form of a coating film formed by coating the composition for forming a coating film explained infra, and the protective layer to be provided on the small space B is preferably the protective layer 14 formed by plugging up with the kneaded caulking composition explained infra.

(2) Plasma CVD equipment

A diagrammatic cross-sectional view of plasma CVD equipment is shown in Fig. 2. In Fig. 2, numeral 21 is a heater, numeral 22 is a dome cover, numeral 23 is a side wall, numeral 24 is a bottom plate, numeral 25 is a ring, numeral 26 is an electrode, numeral 27 is an insulator, numeral 28 is a wafer, numeral 29 is a wafer chuck, numeral 30 is a an exhaust pipe, numeral 31 is a high frequency coil, and numeral 32 are O-rings.

In Fig. 2, the left-hand half thereof shows especially portions to be effectively provided with the protective layer (Symbols A and B), and the right-hand half thereof shows the case that the protective layers 33 and 34 are provided therewith.

In this plasma CVD equipment, examples of edge portions of sharp angle are those indicated by Symbol A, and examples of small spaces are those indicated by Symbol B and formed by O-ring and peripheral members thereof.

The protective layer to be provided on the edge portion A is preferably the protective layer 33 in the form of a coating film formed by coating the composition for forming a coating film explained infra, and the protective layer to be provided on the small space B is preferably the protective layer 34 formed by plugging up with the kneaded caulking composition explained infra.

(3) Ashing equipment

A diagrammatic cross-sectional view of ashing equipment is shown in Fig. 3. In Fig. 3, numeral 41 is a nozzle for feeding gas, numeral 42 is a dome cover, numeral 43 is a side wall, numeral 44 is a bottom plate, numeral 45 is a ring, numeral 46 is an electrode, numeral 47 is an insulator, numeral 48 is a wafer, numeral 49 is a wafer chuck, numeral 50 is an exhaust pipe, numeral 51 is a high frequency coil, and numeral 52 are O-rings.

In Fig. 3, the left-hand half thereof shows especially portions to be effectively provided with the protective layer (Symbols A and B), and the right-hand half thereof shows the case that the protective layers 53 and 54 are provided therewith.

In this ashing equipment, examples of edge portions of sharp angle are those indicated by Symbol A, and examples of small spaces are those indicated by Symbol B and formed by O-ring and peripheral members thereof.

The protective layer to be provided on the edge portion A is preferably the protective layer 53 in the form of a coating film formed by coating the composition for forming a coating film explained infra, and the protective layer to be provided on the small space B is preferably the protective layer 54 formed by plugging up with the kneaded caulking composition explained infra.

A method of forming these protective layers (13, 14, 33, 34, 53, 54) is not particularly limited, and a coating method, a plugging (caulking) method, a brushing method and a method of sticking a sheet comprising the fluorine-containing elastomer (A) may be employed. Also, a method of forming a protective layer on parts and then assembling the parts into equipment or a method of forming a protective layer on assembled equipment by a coating method, etc. may be employed.

When forming a protective layer by a coating method, it is preferable to use a coating composition comprising the fluorine-containing elastomer (A) and an organic solvent (B). Each component is explained below.

(A) Fluorine-containing elastomer

The fluorine-containing elastomer (A) to be used in the present invention may be conventional elastomers.

From the viewpoint of stability and non-contaminating property of the obtained fluorine-containing elastomer, there are, for example, elastomers comprising structural units derived from tetrafluoroethylene (TFE), vinylidene fluoride (VdF), hexafluoropropylene (HFP) and perfluoro vinyl ether represented by the formula (1): $CF_2$=CF-O$R_f$ (in the formula, $R_f$ is a perfluoroalkyl group having 1 to 5 carbon atoms or a perfluoroalkyl (poly)ether group having 1 to 3 oxygen atoms and 3 to 12 carbon atoms).

In addition, the elastomer may comprise other monomer units to an extent not to impair an effect of the present invention and properties of the elastomer. There are exemplified, as other monomers, for example, olefins such as ethylene (Et) and propylene (Pr); iodine-containing fluorinated vinyl ethers imparting good performance as to compression

set and represented by the formula: $I(CH_2CF_2CF_2O)m[CF(CF_3)CF_2O]nCF=CF_2$ (in the formula, m is an integer of 1 to 5, n is 0 or an integer of 1 to 3), and iodinated olefins described in JP7-316246A and represented by the formula:

$$CX_2=CX-R_f^2-CHR-I$$

wherein X is hydrogen atom, fluorine atom or methyl; R is hydrogen atom or methyl; $R_f^2$ is a linear or branched fluoro- or perfluoroalkylene group or fluoro- or perfluorooxyalkylene group which may have at least one ether type oxygen atom. Other examples are $CF_2=CHI$ and perfluoro(5-iodo-3-oxa-1-pentene). Also, there are functional group-containing monomers exemplified below to improve heat resistance.

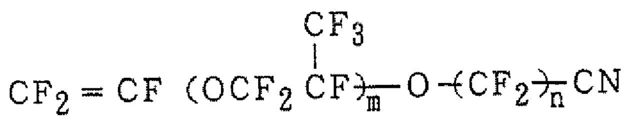

(m: 0 to 5, n:1 to 3)

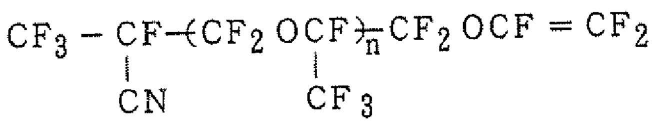

(n: 1 to 4),

$$CF_2=CFO(CF_2)_nOCF(CF_3)CN$$

(n: 2 to 5),

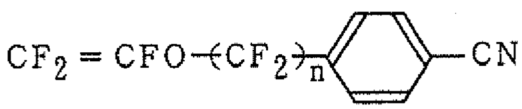

(n: 1 to 6),

$$CF_2 = CF [OCF_2 CF (CF_3)]_n OCF_2 CF (CF_3) CN$$

(n: 1 to 2), or

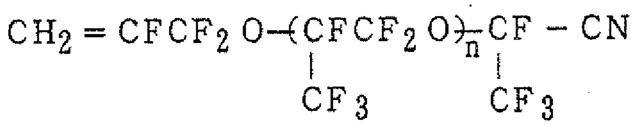

(n: 0 or an integer of 1 to 5)

Preferred examples of a combination of monomers are TFE/perfluoro(alkyl vinyl ether) (PAVE), VdF/HFP, VdF/TFE/HFP, VdF/PAVE/TFE, VdF/perfluoro(methyl vinyl ether) (PMVE), VdF/HFP/PMVE, VdF/TFE/PMVE, VdF/PMVE/HFP/TFE and TFE/Pr/other monomer. The proportion of TFE/PAVE is preferably 40 to 90/ 10 to 60 (mole %), the proportion of VdF/HFP or VdF/TFE/HFP is preferably 30 to 85/0 to 30/15 to 40 (mole %), and the proportion of VdF/PAVE/TFE is preferably 10 to 90/10 to 40/0 to 80 (mole %). The proportion of VdF/PMVE is preferably 65 to 90/10 to 35 (mole %), the proportion of VdF/HFP/PMVE is preferably 65 to 90/3 to 25/3 to 25 (mole %), the proportion of VdF/TFE/PMVE is preferably 40 to 80/3 to 40/15 to 35 (mole %), and the proportion of VdF/PMVE/HFP/TFE is preferably 40 to 80/3 to 25/3 to 25/3 to 40 (mole %). In addition, the proportion of TFE/Pr/other monomer is preferably 40 to 70/30 to 60/0 to 20 (mole %).

Also, the fluorine-containing elastomer (A) to be used in the present invention may be a fluorine-containing multi-segment elastomer disclosed in Japanese Patent Application No. 1997/304684 as a molding material suitably used for molding of various molded articles required to have sealing property and cleanness. Preferred example of a combination of monomers is TFE/PAVE/monomer giving cure site (45 to 90/10 to 50/0 to 5 in mole %, hereinafter the same) as an elastomeric fluorine-containing polymer chain segment, and further preferred mole % is 45 to 80/20 to 50/0 to 5, especially 53 to 70/30 to 45/0 to 2. Examples of a non-elastomeric fluorine-containing polymer chain segment are:

(1) VdF/TFE (0 to 100/100 to 0), especially VdF/TFE (70 to 99/30 to 1), PTFE or PVdF;
(2) Ethylene/TFE/HFP (6 to 60/40 to 81/1 to 30), 3,3,3-trifluoropropylene- 1,2-trifluoromethyl-3,3,3-trifluoropropylene-1 /PAVE (40 to 60/60 to 40);
(3) TFE/ $CF_2$=CF-$R_f^1$ (within a range of mole % showing non-elastomeric property, namely $CF_2$=CF-$R_f^1$: not more than 15 % by mole);
(4) VdF/TFE/CTFE (50 to 99/30 to 0/20 to 1);
(5) VdF/TFE/HFP (60 to 99/30 to 0/10 to 1);
(6) Ethylene/TFE (30 to 60/70 to 40);
(7) Polychlorotrifluoroethylene (PCTFE);
(8) Ethylene/CTFE (30 to 60/70 to 40); and the like.

In addition, fluorine-containing elastomers derived from fluoroether compounds having alkenyl group (fluorine-containing elastomers described, for example, in JP2004-51834A, JP2003-327820A, JP2005-97369A and JP8-198926A) can also be used.

Further, a fluorosilicone elastomer obtained by fluorinating a silicone elastomer may be used.

Among these fluorine-containing elastomers (A), preferred are perfluoroelastomers being excellent especially in properties such as plasma resistance and chemical resistance and being suitably applicable to semiconductor manufacturing equipment.

Also, among perfluoroelastomers, from the viewpoint of further satisfactory heat resistance, a TFE/PAVE type perfluoroelastomer comprising PAVE, TFE and functional group-containing monomer units is preferred. More specifically, a TFE/PAVE type perfluoroelastomer comprising 18 to 33 % by mole of PAVE (especially PMVE) unit, 0.3 to 0.6 % by mole of monomer unit having functional group (especially at least one selected from the group consisting of nitrile group, carboxyl group and alkoxycarbonyl group) and the remaining % by mole of TFE unit is preferred.

The content of PAVE unit in the TFE/PAVE type perfluoroelastomer is not less than 18 % by mole, preferably not less than 20 % by mole, more preferably not less than 23 % by mole, from the points that the elastomer does not have properties close to those of a resin and does not lose rubber elasticity.

In this case, examples of PAVE are, for instance, PMVE, perfluoro(propyl vinyl ether), and the like, which can be used alone or can be used in an optional combination thereof to such an extent not to impair the effect of the present invention.

Of these, PMVE is preferred from the viewpoint of properties of rubber elasticity and satisfactory mechanical strength.

The content of functional group-containing monomer unit is not less than 0.3 % by mole, preferably not less than 0.4 % by mole in the TFE/ PAVE type perfluoroelastomer from the viewpoint of improving adhesion to a substrate and improving sealing property and fixing ability. Also, the content is not more than 0.6 % by mole, preferably not more than 0.5 % by mole from the viewpoint of keeping properties of rubber elasticity.

Examples of the functional group are nitrile, carboxyl, alkoxycarbonyl, hydroxyl and amino. Particularly at least one selected from the group consisting of nitrile, carboxyl and alkoxycarbonyl is preferred from the viewpoint of improving adhesion to a substrate and improving sealing property and fixing ability.

Also, these functional groups may constitute cure sites when a crosslinking agent is used.

Examples of the TFE/PAVE type perfluoroelastomer are those described in JP9-512569A, WO 00/29479, JP11-92529A, etc.

(B) Organic solvent

The organic solvent (B) which can be used in the present invention is not particularly limited as far as the fluorine-containing elastomer (A) can be dissolved or swelled, or can be uniformly dispersed.

Examples of the organic solvent (B) are fluorine-containing solvents, non-fluorine-containing solvents and mixtures thereof, and the organic solvent is optionally selected depending on kind, amount, application form and use of the fluorine-containing elastomer (A).

Of these solvents, fluorine-containing solvents having affinity for the fluorine-containing elastomer (A) is preferred.

In the fluorine-containing solvents, those having hydrogen content of not more than 3 % calculated from chemical structure thereof are preferred, and completely fluorinated solvents having hydrogen content of 0 % is more preferred since the fluorine-containing elastomer (A), especially perfluoroelastomer can be sufficiently dissolved.

Examples of the fluorine-containing solvents are CFC (completely halogenated chlorofluoro carbon), HFC (hydrofluoro carbon), HCFC (hydrochlorofluoro carbon), perfluoro tertiary amines such as perfluorotri-n-butylamine and perfluorotriethylamine; and FLORINATE FC-77 (registered trade mark, available from Sumitomo 3M Limited, predominantly comprising $C_8F_{16}O$). These may be used alone or can be used in combination of two or more thereof.

Examples of non-fluorine-containing solvents are ketones such as methyl isobutyl ketone and isophorone; esters such as butyl acetate and isopentyl acetate; ethers such as diethylene glycol dimethyl ether; hydrocarbons such as toluene and xylene; and amides such as N,N-dimethylacetamide and N-methyl-2-pyrrolidone. These may be used alone or can be used in combination of two or more thereof.

Further, a mixture of a fluorine-containing solvent and a non-fluorine-containing solvent may be used.

The amount of organic solvent (B) varies depending on kind of the solvent and form at use and application of the composition, and the solvent is used in an amount such that the obtained composition has flowability at 25°C (normal temperature). According to the present invention, the solvent is blended so that viscosity of the composition at 25°C becomes 0.4 to 30 Pa·s (4 to 300 [P]).

The composition can be in the form of solution, dispersion, slurry and paste, and the form may be optionally selected depending on the form at use and application.

In the present invention mainly aiming at improvement in plasma resistance, the crosslinking agent (C) may be contained or may not be contained in the coating composition used in the present invention.

In the case of blending the crosslinking agent (C), mechanical strength of the protective layer can be improved by crosslinking the fluorine-containing elastomer (A).

Conventional crosslinking agents can be used as the crosslinking agent (C), and there can be exemplified, for example, peroxide crosslinking agents, polyol crosslinking agents, polyamine crosslinking agents, triazine crosslinking agents, oxazole crosslinking agents, imidazole crosslinking agents, thiazole crosslinking agents and radiation crosslinking agents.

Crosslinking agents to be used in peroxide crosslinking are organic peroxides which can easily generate a peroxy radical in the presence of heat or an oxidation-reduction system, and examples thereof are 1,1-bis(t-butylperoxy)-3,5,5-trimethylcyclohexane, 2,5-dimethylhexane-2,5-dihydro peroxide, di-t-butyl peroxide, t-butylcumyl peroxide, dicumyl peroxide, $\alpha,\alpha$-bis(t-butylperoxy)-p-diisopropyl benzene, 2,5-dimethyl-2,5-di(t-butylperoxy)hexane, 2,5-dimethyl-2,5-di(t-butylperoxy)-hexine-3, benzoyl peroxide, t-butyl peroxybenzene, 2,5-dimethyl-2,5-di(benzoylperoxy)-hexane, t-butyl peroxymaleate, t-butylperoxy isopropylcarbonate, and the like. Among them, dialkyl peroxides are preferred. Further, 2,5-dimethyl-2,5-di(t-butylperoxy)-hexane is especially preferred. Generally, kind and amount of the organic peroxide are selected in consideration of an amount of an active -O-O- and a decomposition temperature.

In addition, a crosslinking accelerator may be used in a peroxide crosslinking system. The crosslinking accelerator is a compound having reactivity with a peroxy radical or a polymer radical, and examples thereof are, for instance, multifunctional compounds having a functional group such as $CH_2$=CH-, $CH_2$=$CHCH_2$- or $CF_2$=CF-. Examples thereof are triallyl cyanurate, triallylisocyanurate (TAIC), triacryl formal, triallyl trimellitate, N,N'-n-phenylenebismaleimide, dipropargyl terephthalate, diallyl phthalate, tetraallyl terephthalamide, triallyl phosphate, bismaleimide, fluorinated triallyl isocyanurate(1,3,5-tris(2,3,3-trifluoro-2-propenyl)-1,3,5-triazine2,4,6-tr ion), tris(diallylamine)-s-triazine, triallyl phosphite, N,N-diallylacrylamide and 1,6-divinyldodecafluorohexane.

Examples of crosslinking agent used for polyol crosslinking are polyhydric alcohol compounds such as bisphenol A and bisphenol AF.

Examples of crosslinking agent used for polyamine crosslinking are polyamine compounds such as hexamethylenediamine carbamate, N,N'-dicinnamylidene-1,6-hexanediamine and 4,4'-bis(aminocyclohexyl)methane carbamate.

Examples of crosslinking agent used for triazine crosslinking are organotin compounds such as tetraphenyltin and triphenyltin.

Examples of crosslinking agent used for oxazole crosslinking system, imidazole crosslinking system and thiazole

crosslinking system are bisdiaminophenyl crosslinking agents, bisaminophenol crosslinking agents and bisaminothiophenol crosslinking agents represented by the general formula (10):

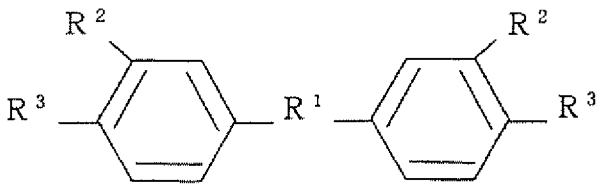 General formula (10)

wherein $R^1$ is $-SO_2-$, -O-, -CO-, an alkylene group having 1 to 6 carbon atoms, a perfluoroalkylene group having 1 to 10 carbon atoms or a single bond; one of $R^2$ and $R^3$ is $-NH_2$, and another one is $-NH_2$, -OH or -SH; and preferably both of $R^2$ and $R^3$ are $-NH_2$,
bisamidrazone crosslinking agents and bisamidoxime crosslinking agents represented by the general formula (11):

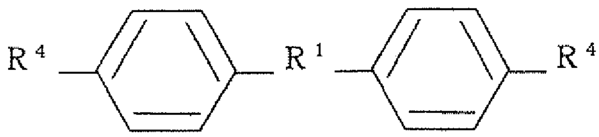 General formula (11)

( $R^1$ is as defined above, $R^4$ is

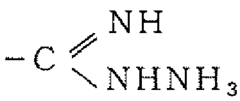

or

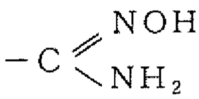

) ,
and bisamidrazone crosslinking agents and bisamidoxime crosslinking agents represented by the general formula (12) or (13):

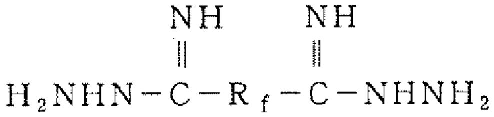 General formula (12)

wherein $R_f$ is a perfluoroalkylene group having 1 to 10 carbon atoms,

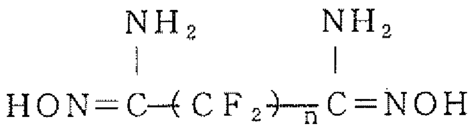 General formula (13)

wherein n is an integer of 1 to 10. These bisaminophenol crosslinking agents, bisaminothiophenol crosslinking agents and bisdiaminophenyl crosslinking agents have been used for crosslinking systems using a nitrile group as cure site, and also react with carboxyl group and alkoxycarbonyl group to form an oxazole ring, a thiazole ring or an imidazole ring, thereby providing a crosslinked article.

Among these crosslinking agents, from the viewpoint of especially satisfactory heat resistance, good crosslinking reactivity and relatively easy synthesis, more preferred crosslinking agents are bisdiaminophenyl crosslinking agents having at least two crosslinkable bisamino functional groups represented by the general formula (14):

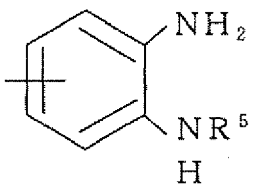 General formula (14)

wherein $R^5$ is fluorine atom or a monovalent organic group. Examples of functional groups reactable with this crosslinkable functional group are nitrile group, carboxyl group and alkoxycarbonyl group, and an imidazole ring is formed by the reaction.

Further, more preferred crosslinking agents are compounds represented by the general formula (15):

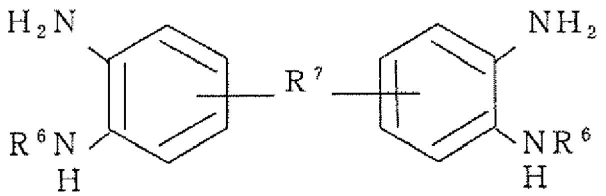 General formula (15)

The substituent $R^6$ in the crosslinkable reaction group is a monovalent organic group other than hydrogen or a fluorine atom, and particularly, a substituent forming N-$R^6$ bond having oxidation resistance higher than that of N-H bond is preferred. Here, "a substituent forming N-$R^6$ bond having oxidation resistance higher than that of N-H bond" means a substituent forming N-$R^6$ bond existing in a compound being hardly oxidized than a compound having N-H bond when an imidazole ring is formed.

Nonlimiting examples of such $R^6$ are aliphatic hydrocarbon groups which may be substituted or a phenyl group or benzyl group which may be substituted.

For example, at least one of $R^6$ is a lower alkyl group having 1 to 10, especially 1 to 6 carbon atoms such as $-CH_3$, $-C_2H_5$ or $-C_3H_7$; a fluorine atom-containing lower alkyl group having 1 to 10, especially 1 to 6 carbon atoms such as $-CF_3$, $-C_2F_5$, $-CH_2F$, $-CH_2CF_3$ or $-CH_2C_2F_5$; phenyl group; benzyl group; phenyl group or benzyl group, in which 1 to 5 hydrogen atoms are replaced by fluorine atoms, such as $-C_6F_5$ or $-CH_2C_6F_5$; or phenyl group or benzyl group, in which 1 to 5 hydrogen atoms are replaced by $-CF_3$, such as $-C_6H_{5-n}(CF_3)_n$ or $-CH_2C_6H_{5-n}(CF_3)_n$ (n is an integer of 1 to 5).

Among these, from the viewpoint of especially satisfactory heat resistance, good crosslinking reactivity and relatively easy synthesis, phenyl group and $-CH_3$ are preferred.

In the compound represented by the general formula (15), $R^7$ is $-SO_2-$, -O-, -CO-, an alkylene group which may be substituted,

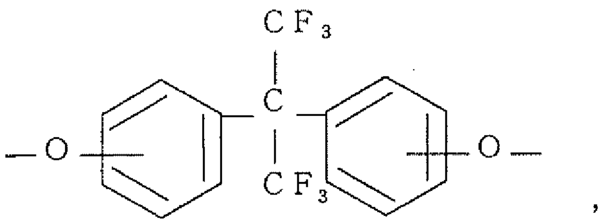

or a single bond.

Nonlimiting examples of an alkylene group of $R^7$ which may be substituted are un-substituted alkylene groups having 1 to 6 carbon atoms or perfluoroalkylene groups having 1 to 10 carbon atoms, and examples of perfluoroalkylene groups are

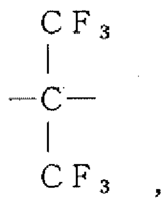

and the like. These $R^7$ are known as exemplified in bisdiaminophenyl compounds described in JP2-59177B and JP8-120146A.

$R^7$ may be bonded to any positions of the right and left benzene rings but it is preferable that $R^7$ is bonded so that either of $NH_2$ group or $NHR^7$ group is located at para-position with respect to $R^7$ from the viewpoint of easy synthesis and easy crosslinking reaction.

Example of especially preferred crosslinking agent is the compound represented by the general formula (16):

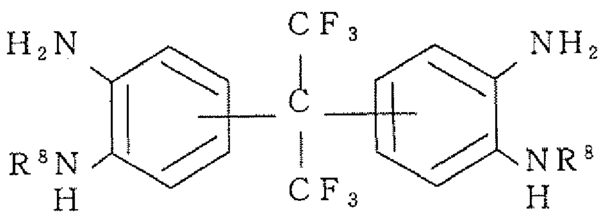

General formula (16)

wherein $R^8$s are the same or different and each is an alkyl group having 1 to 10 carbon atoms, an alkyl group having fluorine atom and 1 to 10 carbon atoms, a phenyl group, a benzyl group, or a phenyl group or benzyl group, in which 1 to 5 hydrogen atoms are replaced by fluorine atoms or $-CF_3$.

Nonlimiting examples of the compound are, for instance, 2,2-bis-[3-amino-4-(N-methylamino)phenyl]hexafluoropropane, 2,2-bis-[3-amino-4-(N-ethylamino)phenyl]hexafluoropropane, 2,2-bis-[3-amino-4-(N-propylamino)phenyl]hexafluoropropane, 2,2-bis-[3-amino-4-(N-phenylamino)phenyl]hexafluoropropane, 2,2-bis-[3-amino-4-(N-perfluorophenylamino)phenyl]hexafluoropropane, 2,2-bis-[3-amino-4-(N-benzylamino)phenyl]hexafluoropropane, 2,2-bis-(3-amino-4-hydroxyphenyl)hexafluoropropane (common name: bis(aminophenol)AF), 2,2-bis-(3-amino-4-mercaptophenyl)hexafluoropropane, tetraaminobenene, bis-3,4-diaminophenylmethane, bis-3,4-diaminophenyl ether, 2,2-bis(3,4-diaminophenyl)hexafluoropropane, and the like.

The crosslinking agents explained above provide crosslinked articles being excellent in mechanical strength, heat resistance and chemical resistance, especially crosslinked articles having well-balanced heat resistance and chemical resistance.

The amount of crosslinking agent is preferably 0.05 to 10 parts by mass, more preferably 1 to 5 parts by mass based on 100 parts by mass of the fluorine-containing elastomer (A). When the amount of crosslinking agent is smaller than 0.05 part by mass, there is a tendency that the fluorine-containing elastomer is not crosslinked sufficiently, and

when the amount of crosslinking agent exceeds 10 parts by mass, physical properties of crosslinked articles tend to be lowered.

Crosslinking conditions need to be optionally decided depending on kind of a crosslinking agent to be used, and usually crosslinking at 150° to 300°C for one minute to 24 hours can be adopted.

The composition may be solidified simply as it is in an un-crosslinked state without blending a crosslinking agent. In this case, the composition is easily applied (coated) and easily handled, there is no dimensional change (shrinkage) by crosslinking, and deteriorated protective film is easily replaced or removed. In addition, means and step for eliminating contamination and dispersion failure attributable to a crosslinking agent can be omitted.

(D) Filler

To the composition to be used in the present invention may be blended various additives as case demands. When no crosslinking is carried out, among such additives, a filler providing improvement in mechanical characteristics is a useful additive.

Examples of filler are inorganic fillers such as carbon black and metallic oxides and organic fillers such as engineering resin powders. Examples of metallic oxides are aluminum oxide, magnesium oxide, titanium oxide and silicon oxide, and examples of organic fillers are imide fillers having imide structure such as polyimide, polyamide imide and polyether imide; polyarylate, polysulfone, polyether sulfone, polyphenylene sulfide, polyether ether ketone, polyoxybenzoate, and polytetrafluoroethylene (PTFE).

For example, in the case of application to members for semiconductor manufacturing equipment attended with generation of plasma, plasma-resistant fillers such as high purity silicon oxide, titanium oxide, polyamide and polyimide are preferred.

Depending on form of the composition, form at use and application, at least one of these fillers is used in an amount such that the obtained composition has flowability at 25°C (normal temperature). In the present invention, it is preferable to blend the filler so that viscosity at 25°C becomes 0.4 to 30 Pa·s.

Examples of other additives are a processing aid, a plasticizer, a coloring agent, a stabilizer and an adhesion aid.

The coating composition can be prepared by mixing each components other than the organic solvent by using usual elastomer processing machine, for example, an open roll, a Banbury mixer or a kneader to make a compound and then subjecting the compound to dissolving, swelling and dispersing in the organic solvent. The composition can also be prepared by mixing each component using an internal mixer such as a ball mill.

For applying the coating composition to surfaces of members of the processing apparatus, known methods such as a coating method, a filling method, a kneading and plugging method and a pressure adhering method can be used depending on form of the composition, viscosity, application, and applied parts (wide or narrow).

The composition applied to a substrate is cured by crosslinking or is solidified without crosslinking to form a protective layer.

When a crosslinking agent is not blended, the composition becomes solid by solidifying through removal of the organic solvent. When removing the solvent or even after the removal, in principle, crosslinking is not caused. A method of removing the organic solvent is not limited particularly as far as the removing is carried out under conditions not causing crosslinking. For removing the organic solvent, drying by forced heating, air drying and vacuum drying are preferred.

The obtained solid shows a small dimensional change due to heat and exhibits satisfactory performances such as plasma resistance, high heat conductivity and reduced number of particles. Also, since no crosslinking is applied to the solid, it can be easily dissolved and removed with a solvent.

Especially a small dimensional change due to heat is demonstrated by the fact that in the following sagging test, a percentage of change (150°C) is not more than 20 %. Also, it is preferable that a percentage of change in the sagging test at 100°C is not more than 20 %, and further, it is preferable that a percentage of change in the sagging test at 200°C is not more than 20 %.

Sagging test:

A 3 mm thick 10 mm x 10 mm square solid is placed on a horizontal plate, and after heating at 150°C for one hour, a thickness of the solid is measured to calculate a percentage of change in thickness.

$$\text{Percentage of change in thickness (\%)} = [\{3\ \text{mm} - \text{Thickness after heating (mm)}\} / 3\ \text{mm}] \times 100$$

In the present invention, the coating composition to be used for forming a protective layer is in the form of a

composition for caulking or a composition for forming a coating film, and depending on the form of the composition, there are suitable kind and combination of each component and viscosity, which are explained below respectively.

(1) Composition for caulking

In the present invention, the composition for caulking is suitable for sealing of spaces such as a clearance between the members, for example the above-mentioned small space B, unnecessary hole and dents. In this case, proper adhesion to the members and a small dimensional change at solidifying are especially required.
Further, reduction of a dimensional change after the caulking, workability at caulking (sealing) and drying method need to be taken into consideration.
In the composition for caulking, the organic solvent (B) is used in an amount such that the obtained composition has flowability at 25°C (normal temperature). For example, the solvent is used so as to give viscosity at 25°C of 4 to 300 [P] (0.4 to 30 Pa·s), especially 70 to 300 [P] (7 to 30 Pa·s). When viscosity is smaller, for example, smaller than 4 [P] (0.4 Pa·s), there is a tendency that flowability becomes high and sagging is easily caused, thereby making caulking work difficult. When viscosity is larger than 300 [P] (30 Pa·s), there is a tendency that flowability is lost and a solid sufficient for sealing is hardly obtained.
Though a ratio of the fluorine-containing elastomer (A) to the organic solvent (B) giving a viscosity within the above-mentioned range greatly varies depending on kind of them, an unrestricted ratio of (A)/(B) (mass ratio) is 5/95 to 10/90.
The composition for caulking of which viscosity is within the range mentioned above shows a form of high density solution, slurry or paste, and sealing work is easy.
To the composition for caulking of the present invention may be blended the crosslinking agent (C). However, since in some cases, a dimensional change such as shrinkage due to crosslinking occurs, sealing need to be carried out in consideration of it.
When blending the filler (D), its amount may be adjusted to be within a range, for example, from 20 to 40 parts by mass based on 100 parts by mass of the fluorine-containing elastomer so as to give a viscosity within the range mentioned above.

(2) Composition for forming a coating film

In the present invention, "forming a coating film" means formation of a coating film as a protective layer on a member, and includes local formation of a coating film for repairing defective parts of a protective layer due to deterioration. Therefore, the composition is especially required to have proper adhesion to a member.
Further, it is necessary to consider workability at coating and it is necessary that a coated film can be seen with naked eyes.
In the composition for forming a coating film, the organic solvent (B) is used in an amount such that the obtained composition for forming a coating film has flowability at 25°C (normal temperature). In the composition for forming a coating film of the present invention, the solvent is blended so as to give viscosity at 25°C of 0.4 to 30 Pa·s (4 to 300 [P]), especially 0.4 to 7 Pa·s (4 to 70 [P]). When viscosity is smaller than 0.4 Pa·s (4 [P]), flowability becomes very high and in some cases, it becomes difficult to form a smooth coating film. When viscosity is larger than 30 Pa·s (300 [P]), flowability becomes low and it becomes difficult to form a uniform coating film.
Though a ratio of the fluorine-containing elastomer (A) to the organic solvent (B) greatly varies depending on kind of them, an unrestricted ratio of (A)/B) (mass ratio) is 5/95 to 10/90.
The composition for forming a coating film of which viscosity is within the range mentioned above shows a form of solution or dispersion, and coating work is easy.
To the composition for forming a coating film of the present invention may be blended the crosslinking agent (C). However, since in some cases, a dimensional change such as shrinkage due to crosslinking occurs and additional crosslinking works are necessary, sealing need to be carried out in consideration of it.
When blending the filler (D), its amount may be adjusted to be, for example, 20 to 40 parts by mass based on 100 parts by mass of the fluorine-containing elastomer (A) so as to give a viscosity within the range mentioned above.
Coating of the composition for forming a coating film can be carried out, for example, by dip coating, casting, spray coating, brush coating or curtain flow coating.
In addition, the composition for forming a coating film can be used for repairing a defective part of the protective layer. It is preferable that the composition for forming a coating film for repairing is the same or the same kind as the composition for the protective layer from the viewpoint of good adhesion. A method of repairing may be the same as in the method of forming a coating film.
Fields and equipment where the processing apparatus of the present invention using plasma are used are, for example, those exemplified below.

Field of semiconductor manufacturing equipment:

CVD equipment, dry etching equipment, wet etching equipment, oxidation and diffusion equipment, sputtering equipment, ashing equipment, plasma cleaning equipment, ion implantation equipment, lithography equipment, etc.

Field of liquid crystal panel manufacturing equipment:

CVD equipment, dry etching equipment, wet etching equipment, oxidation and diffusion equipment, sputtering equipment, ashing equipment, plasma cleaning equipment, ion implantation equipment, lithography equipment, etc.

Field of solar cell manufacturing equipment:

CVD equipment, diffusion equipment, sputtering equipment, etc.

## EXAMPLE

The present invention is then explained by means of examples, but is not limited to them.
In the present invention, each of physical properties is measured by the following methods.

(Viscosity)

Viscosity is measured according to JIS Z8803 (25°C).

(Adhesion)

Between two SUS 304 stainless steel plates (50 mm x 40 mm) is coated 1 g of a fluorine-containing elastomer composition, and the composition is dried at room temperature for two days to make a test piece. The two SUS 304 stainless steel plates of the test piece are pulled horizontally in opposite directions with a tension tester (AG-I available from Shimadzu Corporation), and strength ($N/mm^2$) when peeled is assumed to be adhesion strength.

(Plasma resistance)

On a SUS 304 stainless steel plate is coated 1 g of a fluorine-containing elastomer composition by a blade method, and the composition is dried at room temperature for one day to make a test piece. This test piece is irradiated with $O_2$ plasma (800 W, 16 sccm, 600 sec) using plasma equipment (high density plasma etching equipment: RIE-101iPH available from SAMCO, Inc.), and an amount (mass %) of weight reduction after the irradiation is determined.

(Sagging)

A fluorine-containing elastomer composition is cast on a polyester film and is dried at room temperature for two days to make a 3 mm thick solid sheet. This solid sheet is heated for one hour in an oven set at 60°C to completely remove a solvent.
The obtained dried solid sheet is cut into a square of 10 mm x 10 mm to make a 3 mm thick test piece. This test piece is placed on a horizontal plate in an oven set at 100°C, 150°C and 200°C, and is heated at the respective set temperature for one hour. A thickness (mm) of the test piece after the heating is measured, and a change rate (%) of the thickness is calculated.

(Workability)

Workability of coating when making a test piece at the adhesion test, plasma resistance test and sagging test is evaluated.
Workability is evaluated by the following criteria.

O: Coating can be done without nonuniformity.
Δ: Coating can be done though nonuniformity partly occurs.
×: Nonuniformity occurs on a large portion of coating, and coating cannot be done uniformly

(Removability)

The heated sample sheet used for the sagging test is dipped in the same organic solvent as used in preparation of the fluorine-containing elastomer composition at 40°C for 24 hours, and a state of dissolution is observed with naked eyes to evaluate by the following criteria.

O : A sample sheet is dissolved nearly completely and a solvent becomes transparent.
Δ: An un-dissolved portion partly remains and a solvent gets turbid.
×: A sample sheet is hardly dissolved.

EXAMPLE 1

A transparent fluorine-containing elastomer composition in the form of solution having a solid content of 5 % by mass (viscosity: 0.42 Pa·s (4.2 [P])) was prepared by using TFE/PMVE/$CF_2$=$CFOCF_2CF(CF_3)OCF_2CF_2CN$(CNVE) (=58.5/41.0/0.5 mole %) (A-1) as the fluorine-containing elastomer (A) and dissolving 5 parts by mass of this fluorine-containing elastomer (A-1) in 195 parts by mass of FLORINATE FC-77 (B-1) as the fluorine-containing solvent (B).
Next, adhesion, plasma resistance, sagging, removability and workability were examined by using the obtained fluorine-containing elastomer composition. The results are shown in Table 1.

EXAMPLES 2 to 4

Fluorine-containing elastomer compositions were prepared in the same manner as in Example 1 except that a blending amount was adjusted to give a solid content shown in Table 1.
Next, adhesion, plasma resistance, sagging, removability and workability were examined by using the obtained fluorine-containing elastomer compositions. The results are shown in Table 1.

EXAMPLE 5

A fluorine-containing elastomer composition was prepared by further blending 0.9 part by mass of 2,2-bis[3-amino-4-(N-phenylamino)phenyl]hexafluoropropane (AFTA-Ph) as a crosslinking agent to the composition of Example 2.
Between two SUS 304 stainless steel plates (50 mm x 40 mm) was coated 1 g of this fluorine-containing elastomer composition containing the crosslinking agent, and the composition was air-dried for 30 minutes and then dried in an oven set at 80° to 100°C for another 30 minutes, further followed by crosslinking by heating at 200°C for ten minutes. Thus a test piece for adhesion test was prepared, and adhesion was evaluated. The results are shown in Table 1.
In addition, in order to examine plasma resistance and sagging, the fluorine-containing elastomer composition containing the crosslinking agent was subjected to drying and crosslinking (air-drying for 30 minutes, 30-minute drying in an oven set at 80° to 100°C, and crosslinking by heating at 200°C for ten minutes) to make a test piece, and plasma resistance, sagging, removability and workability were examined. The results are shown in Table 1.

TABLE 1

| | Example | | | | |
|---|---|---|---|---|---|
| | 1 | 2 | 3 | 4 | 5 |
| Fluorine-containing elastomer (A-1) | | | | | |
| Organic solvent (B-1) | | | | | |
| Solid content of (A-1) (mass %) | 5 | 10 | 20 | 30 | 10 |
| Viscosity (25°C:Pa·s) | 0.42 | 6.98 | >200 | >200 | 7.05 |
| Adhesion ($N/mm^2$) | 0.037 | 0.029 | 0.030 | 0.030 | 0.045 |
| Plasma resistance (mass %) | 31.07 | 26.17 | 31.31 | 35.53 | 3.39 |
| Sagging (mm) 100°C | 1.5 | 0.60 | 0.50 | 0.6 | 0.3 |
| Sagging (mm) 150°C | 2.0 | 1.20 | 1.20 | 2.6 | 0.4 |
| Sagging (mm) 200°C | 2.4 | 2.5 | 2.1 | 3.9 | 0.5 |
| Removability | O | O | O | O | Δ |
| Workability | O | O | O | Δ | O |

EXAMPLE 6

A transparent fluorine-containing elastomer composition in the form of solution having a solid content of 5 % by mass (viscosity: 0.18 Pa·s (1.8 [P])) was prepared by using, as the fluorine-containing elastomer (A), TFE/PMVE/CNVE (=56.6/42.3/1.1 mole %) (A-2) prepared in the same manner as in Preparation Example 1 of WO 2005/049746 and dissolving 10 parts by mass of this fluorine-containing elastomer (A-2) in 190 parts by mass of FLORINATE FC-77 (B-1) as the fluorine-containing solvent (B).

Next, adhesion, plasma resistance, sagging, removability and workability were examined by using the obtained fluorine-containing elastomer composition. The results are shown in Table 2.

EXAMPLES 7 and 8

Fluorine-containing elastomer compositions were prepared in the same manner as in Example 6 except that a blending amount was adjusted to give a solid content shown in Table 2.

Next, adhesion, plasma resistance, sagging, removability and workability were examined by using the obtained fluorine-containing elastomer compositions. The results are shown in Table 2.

TABLE 2

| | Example | | |
|---|---|---|---|
| | 6 | 7 | 8 |
| Fluorine-containing elastomer (A-2) | | | |
| Organic solvent (B-1) | | | |
| Solid content of (A-2) (mass %) | 10 | 20 | 30 |
| Viscosity (25°C: Pa·s) | 0.18 | 4.14 | >200 |
| Adhesion (N/mm$^2$) | N/A | 0.0028 | 0.045 |
| Plasma resistance (mass %) | 33.03 | 26.39 | 24.11 |
| Sagging (mm) 100°C | 14.8 | 13.8 | 11.0 |
| Sagging (mm) 150°C | 34.2 | 30.5 | 33.9 |
| Sagging (mm) 200°C | 50.4 | 36.8 | 35.3 |
| Removability | O | O | O |
| Workability | O | O | Δ |

EXAMPLES 9 to 16

Fluorine-containing elastomer compositions were prepared in the same manner as in Example 1 except that fluorine-containing elastomers (A-1) and (A-2) were used together as the fluorine-containing elastomer (A), and (A-1) was mixed in a ratio (mass %) shown in Table 3 to give a solid content of 10 % by mass.

Next, adhesion, plasma resistance, sagging, removability and workability were examined by using the obtained fluorine-containing elastomer compositions. The results are shown in Table 3.

TABLE 3

| | Example | | | | | | | |
|---|---|---|---|---|---|---|---|---|
| | 9 | 10 | 11 | 12 | 13 | 14 | 15 | 16 |
| Fluorine-containing elastomer | | | | | | | | |
| (A-1)/{(A-1)+(A-2)}×100 | 0 | 10 | 25 | 40 | 50 | 75 | 90 | 100 |
| Organic solvent (B-1) | | | | | | | | |
| Solid content of (A-1)+(A-2) (mass %) | 10 | 10 | 10 | 10 | 10 | 10 | 10 | 10 |
| Viscosity (25°C: Pa·s) | 0.18 | 0.62 | 1.85 | 3.24 | 4.15 | 5.88 | 6.55 | 6.98 |
| Adhesion (N/mm$^2$) | N/A | N/A | 0.018 | 0.022 | 0.028 | 0.031 | 0.029 | 0.029 |
| Plasma resistance (mass %) | 33.03 | 24.38 | 30.84 | 26.58 | 29.58 | 22.54 | 22.04 | 26.17 |
| Sagging (mm) 100°C | 14.8 | 13.3 | 12.1 | 12.2 | 4.9 | 2.3 | 1.1 | 0.5 |
| Sagging (mm) 150°C | 34.2 | 26.2 | 24.0 | 18.8 | 9.7 | 7.40 | 5.7 | 2.0 |

(continued)

| | Example | | | | | | | |
|---|---|---|---|---|---|---|---|---|
| | 9 | 10 | 11 | 12 | 13 | 14 | 15 | 16 |
| Sagging (mm) 200°C | 40.8 | 33.2 | 24.9 | 20.2 | 14.0 | 9.5 | 6.4 | 2.1 |
| Removability | O | O | O | O | O | O | O | O |
| Workability | Δ | Δ | O | O | O | O | O | O |

## Claims

1. A processing apparatus using plasma, which has a protective layer comprising a fluorine-containing elastomer (A) on the whole or a part of surfaces exposed to plasma in the processing apparatus.

2. The processing apparatus of Claim 1, wherein the fluorine-containing elastomer (A) is a not-crosslinked fluorine-containing elastomer.

3. The processing apparatus of Claim 1, wherein the fluorine-containing elastomer (A) is a crosslinked fluorine-containing elastomer.

4. The processing apparatus of any of Claims 1 to 3, wherein the fluorine-containing elastomer (A) further comprises a filler.

5. The processing apparatus of any of Claims 1 to 4, wherein the fluorine-containing elastomer (A) is a perfluoroelastomer.

6. The processing apparatus of any of Claims 1 to 5, wherein the protective layer is provided at least on a surface of an edge portion exposed to plasma in the processing apparatus.

7. The processing apparatus of any of Claims 1 to 6, wherein the protective layer is provided at least on a surface profiling a small space exposed to plasma in the processing apparatus.

8. The processing apparatus of any of Claims 1 to 7, wherein the processing apparatus using plasma is a plasma etching equipment.

9. The processing apparatus of any of Claims 1 to 7, wherein the processing apparatus using plasma is a plasma CVD equipment.

10. The processing apparatus of any of Claims 1 to 7, wherein the processing apparatus using plasma is an ashing equipment,

FIG. 1

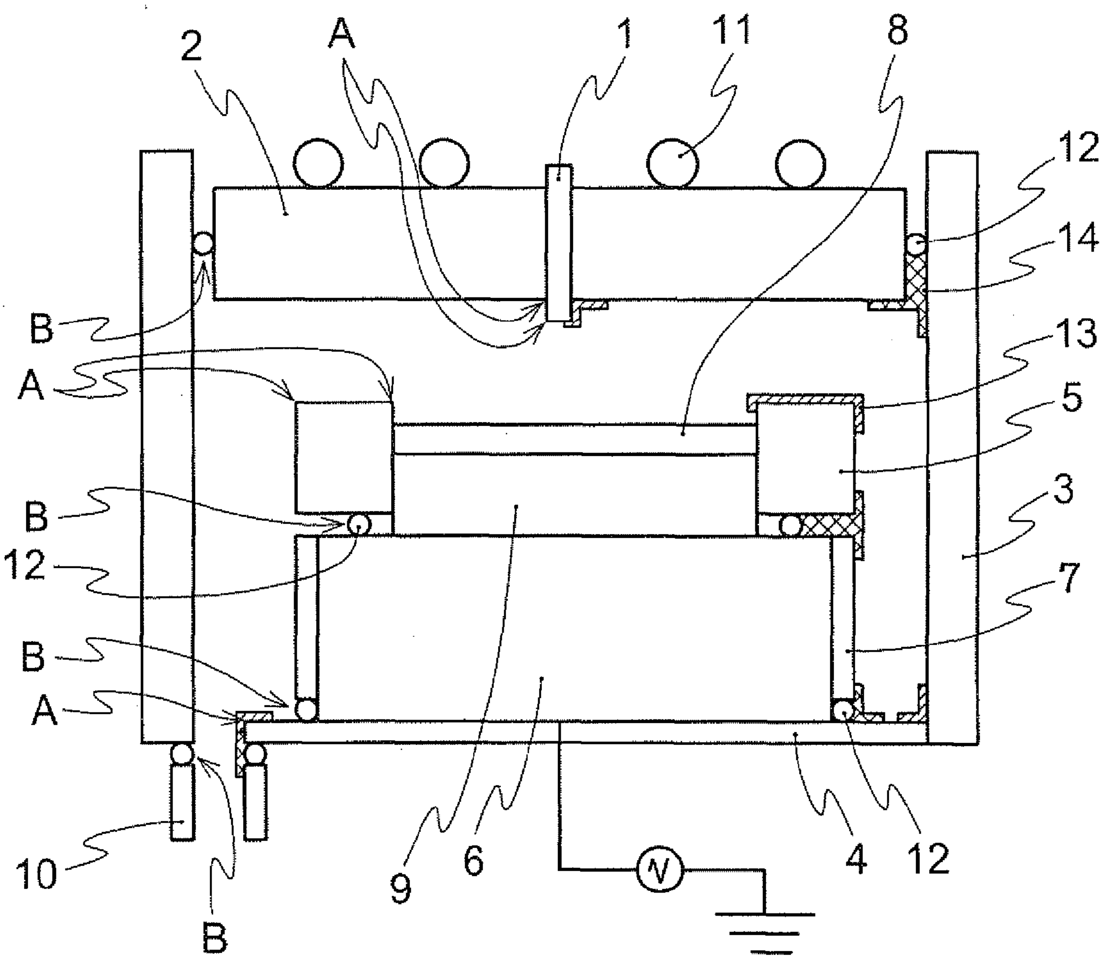

FIG. 2

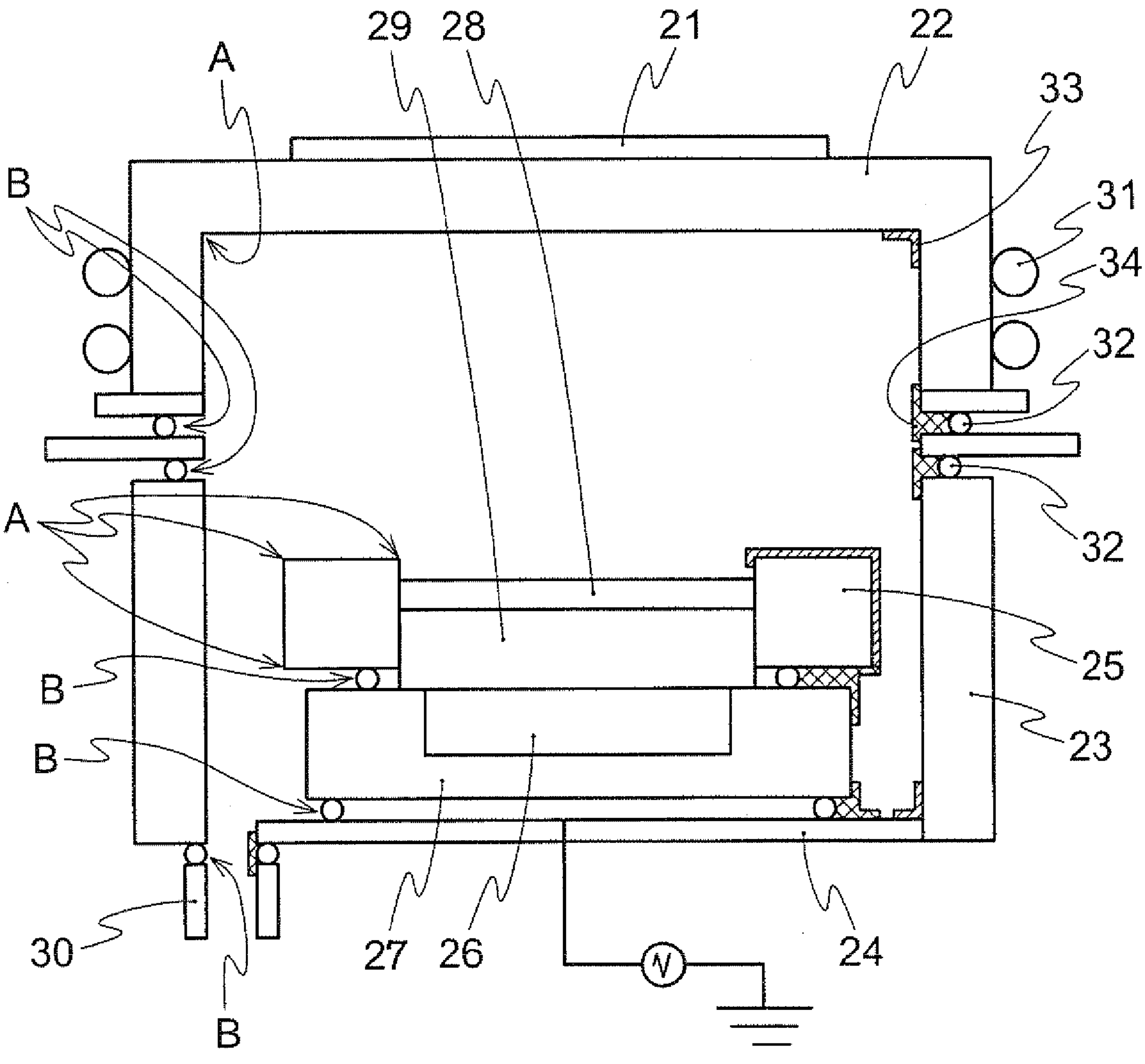

FIG. 3

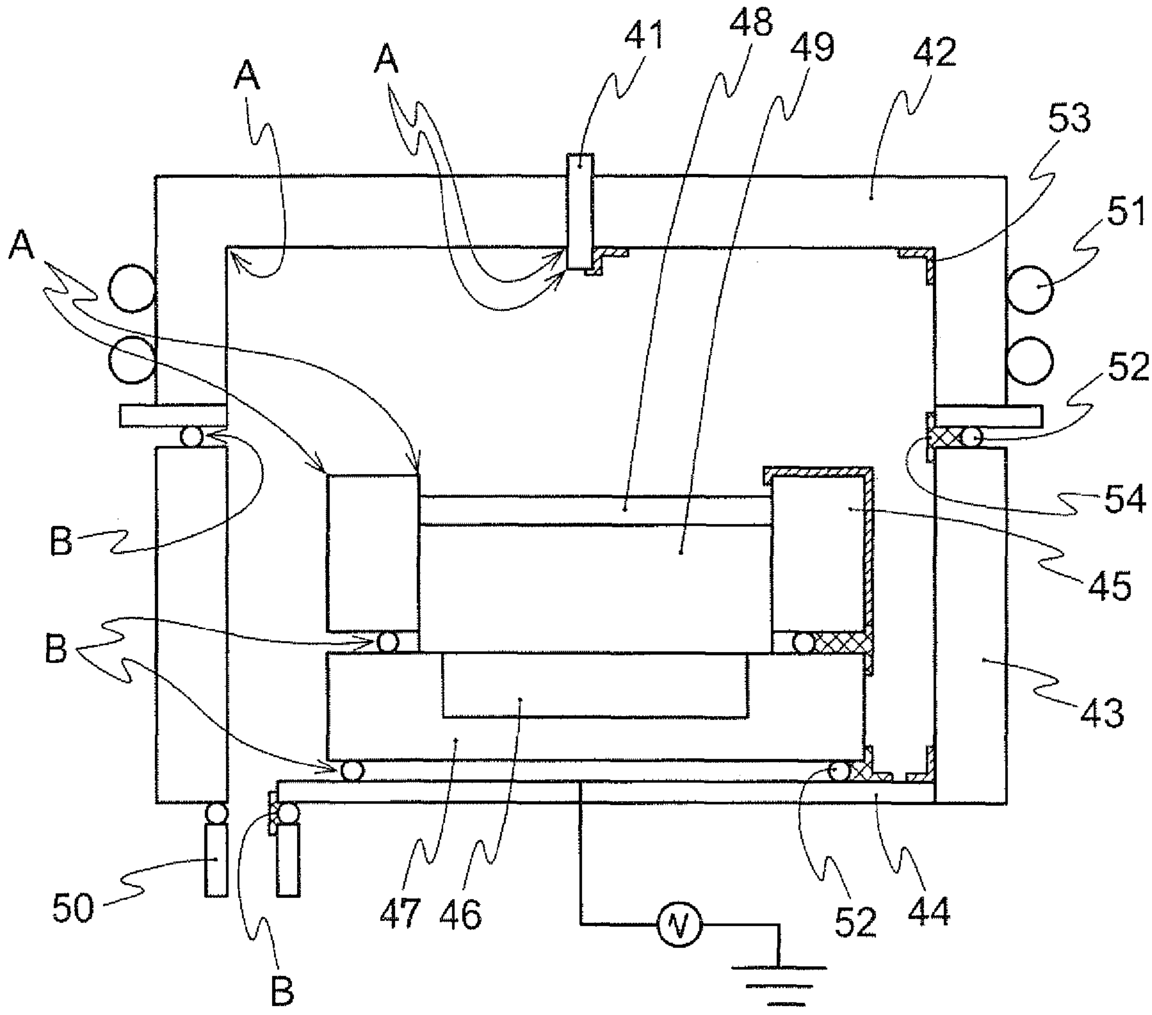

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7495046 B
- US 20060235140 A
- US 20070098978 A
- JP 7316246 A
- JP 9304684 A
- JP 2004051834 A
- JP 2003327820 A
- JP 2005097369 A
- JP 8198926 A
- JP 9512569 A
- WO 0029479 A
- JP 11092529 A
- JP 2059177 B
- JP 8120146 A
- WO 2005049746 A